# FASCICULE DE BREVET EUROPEEN

(11) **EP 0 864 398 B1**
(45) Date de publication et mention de la délivrance du brevet: **14.07.2004**
(21) Numéro de dépôt: 97104024.1
(22) Date de dépôt: 11.03.1997
(51) Int. Cl.: B23Q 3/155

(54) **Machine-outil pourvue d'un magasin d'outils unique à capacité de stockage élevée, et magasin d'outils destiné à équiper une machine-outil**
Werkzeugmaschine mit einem Werkzeugmagazin mit erhöhter Kapazität und Werkzeugmagazin zum Ausrüsten einer Werkzeugmaschine
Machine tool with tool store with improved capacity and tool store for equipping a machine tool

(43) Date de publication de la demande: 16.09.1998
(73) Titulaire: Posalux S.A., 2500 Bienne 6 (CH)
(72) Inventeur: Soltermann, Claude, CH-2560 Nidau (CH); Imhof, Werner, CH-2503 Bienne (CH); Faoro, Alexandre, CH-2520 La Neuveville (CH)
(74) Mandataire: Ravenel, Thierry Gérard Louis

(56) Documents cités:
- EP-A- 0 541 020
- EP-A- 0 555 576
- DD-A- 216 667
- DE-A- 3 539 662
- DE-U- 8 915 599
- DE-U- 9 010 220

## Description

La présente invention concerne une machine-outil pourvue d'au moins une station d'usinage destinée à réaliser des opérations d'usinage sur des pièces à usiner, notamment sur des plaques de circuits imprimés, en utilisant des outils et, plus particulièrement, une machine-outil pourvue d'au moins une station d'usinage et d'un magasin de stockage d'outils unique ayant une capacité de stockage élevée selon le préambule de la revendication 1.

La présente invention concerne aussi un magasin d'outils destiné à équiper une telle machine-outil selon le préambule de la revendication 24.

On utilise classiquement des machines-outils pourvues d'au moins une station d'usinage pour la réalisation automatique d'opérations de perçage, de contournage, de fraisage sur des pièces à usiner, en particulier des plaques de circuits imprimés.

La demande de brevet britannique No 2 128 909 au nom du demandeur de la présente invention décrit une machine-outil pourvue d'au moins une station d'usinage, capable d'usiner des plaques de dimensions quelconques.

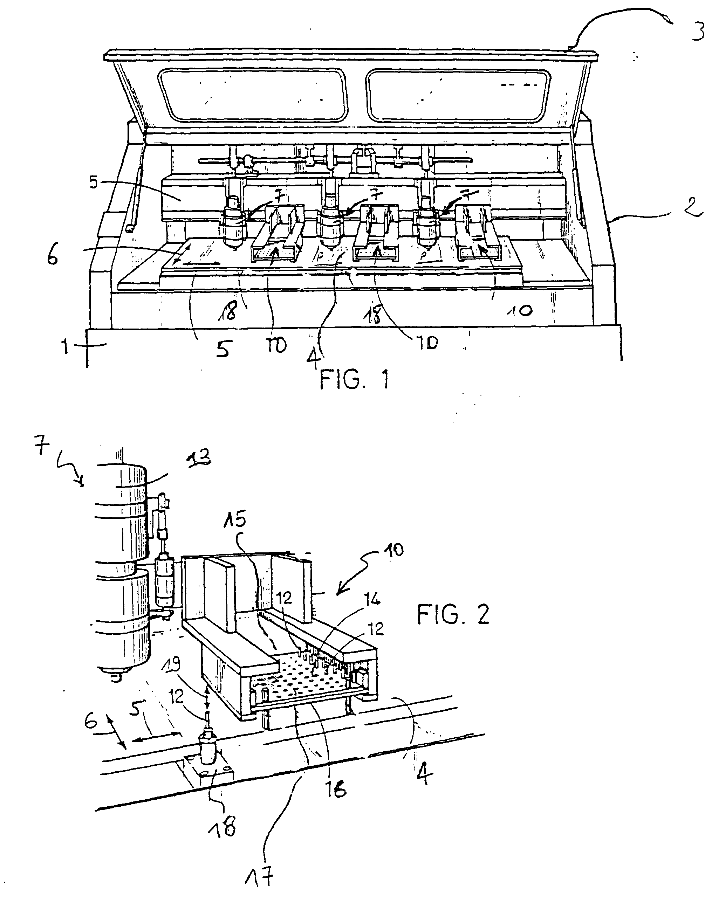

La figure 1 représente une vue générale d'un mode de réalisation de machine-outil selon l'art antérieur.

Une telle machine-outil comprend essentiellement un bâti 1 surmonté d'un carter 2 muni d'un capot 3 susceptible d'être placé en position ouverte, ce qui permet d'avoir accès à la zone de travail et à différents organes de la machine-outil. Le bâti comprend notamment une table porte-pièces 4 mobile dans deux directions perpendiculaires désignées par les axes 5 et 6, sous l'action de moyens de commande (non représentés) et de moyens de guidage (non représentés).

La table porte-pièces 4 est équipée de moyens de fixation (non représentés) pour assurer la fixation des pièces à usiner qui, dans l'exemple représenté en figure 1, correspondent à des plaques de circuits imprimés désignées par les références P.

Cette machine-outil comprend aussi trois stations d'usinage 7, comme cela est représenté en figure 1. Il va de soi que ce nombre de stations d'usinage est purement illustratif.

Dans le document cité ci-dessus, la table porte-pièces et les moyens de guidage sont solidaires du bâti et les stations d'usinage sont fixes. Ceci a pour effet de permettre un mouvement des stations d'usinage par rapport à la table porte-pièces.

En outre, les stations d'usinage sont mobiles simultanément ou indépendamment dans une troisième direction (axe Z) perpendiculaire aux deux autres directions. On peut ainsi exécuter simultanément le même motif d'usinage sur les plaques P associées à chaque station de travail.

Chaque station d'usinage 7 comporte une broche 13 motorisée destinée à recevoir et à entraîner en rotation un outil 12 pour réaliser une opération d'usinage déterminée. L'outil 12 peut être un foret, une fraise, ou tout autre outil pouvant servir à usiner les plaques P.

Une pluralité d'outils est disponible dans un ou plusieurs emplacements de stockage ou magasins, désignés par la référence 10 en figure 1. La figure 2 représente de façon plus détaillée le magasin d'outils décrit dans la demande de brevet citée ci-dessus. Le magasin d'outils est associé à chaque station d'usinage 7, et est constitué d'une cassette amovible 14 montée de façon à coulisser dans un logement 15. La cassette 14 comprend une plaque 16 pourvue d'un réseau matriciel de trous 17, chaque trou 17 étant destiné à recevoir un outil 12.

La machine-outil comprend en outre un dispositif de transfert 18 solidaire de la table porte-pièces 4. Le dispositif de transfert comprend un changeur 18 qui permet la charge et la décharge d'un outil 12 dans un trou 17 de la cassette 14. Comme cela est représenté de façon plus détaillée en figure 2, le dispositif 18 est solidaire de la table porte-pièces 4, et peut recevoir un outil 12. Le mouvement du dispositif de transfert par rapport aux stations d'usinage permet à l'outil 12 concerné d'être déchargé de la station d'usinage 7 concernée selon une direction désignée par l'axe 19. Sous l'action combinée des moyens de commande et des moyens de guidage, le remplacement de l'outil est alors réalisé.

On peut citer encore le brevet EP 0 541 020 qui décrit un dispositif de changement d'outils dans une machine-outil, notamment opérant sur des circuits imprimés. Un tambour d'outils est prévu sur un des côtés de la machine à proximité d'une zone de travail. Le tambour comprend plusieurs rangées de cellules sur toute sa périphérie dans lesquelles sont placés des outils indépendants ou des supports d'outils. Un dispositif de changement d'outil est commandé pour venir chercher automatiquement un outil dans le tambour qui est tourné pour sélectionner la rangée d'outils souhaitée, afin de conduire l'outil saisi à la station de travail pour usiner une pièce.

Lors de l'opération de la machine-outil, il est difficile de venir changer un outil ou un support d'outils dans le tambour qui se trouve proche de la zone de travail, car lorsque le dispositif de changement d'outils vient prendre un outil, le tambour est activé, ce qui peut créer un risque pour l'utilisateur.

De telles machines-outils présentent de nombreux inconvénients.

Un inconvénient de ces machines-outils réside dans le fait qu'il est nécessaire d'interrompre leur fonctionnement pour décharger et charger des cassettes d'outils spécifiques pour réaliser des opérations d'usinage spécifiques, et pour renouveler des cassettes d'outils dès que les outils sont déclarés usés. Ceci occasionne une perte de temps notable lors du cycle de fabrication et, par conséquent, une perte de rendement d'une machine-outil de ce type, ce qui va à l'encontre des exigences et contraintes industrielles courantes. Par ailleurs, le fait que l'opérateur doit intervenir directement dans la zone de travail d'une telle machine-outil au cours des interventions susmentionnées peut occasionner des risques pour ledit utilisateur.

Un autre inconvénient de ces machines-outils réside dans la faible capacité de stockage des magasins d'outils tels que décrits ci-dessus, ce qui limite notablement l'autonomie de ces machines-outils.

Un objet de la présente invention est de prévoir une machine-outil pourvue d'au moins une station d'usinage, qui pallie les inconvénients susmentionnés de l'art antérieur.

Cet objet, ainsi que d'autres, est atteint par une machine-outil destinée à réaliser des opérations d'usinage, notamment sur des plaques de circuits imprimés, comprenant: un bâti ayant au moins une extrémité; un porte-pièces solidaire du bâti; au moins une station d'usinage propre à recevoir sélectivement un outil pour exécuter les opérations d'usinage dans une zone de travail; des moyens de guidage pour assurer un mouvement relatif entre la (ou les) station(s) d'usinage et le porte-pièces; au moins un magasin d'outils constitué d'une pluralité de supports-mères connectés les uns aux autres pour stocker une pluralité d'outils, chaque support-mère étant susceptible de recevoir et de maintenir une pluralité de supports-filles destinés à porter au moins deux outils; un dispositif de transfert d'outil pour recevoir un outil; et des moyens de commande sous l'action desquels est entraîné le magasin d'outils; caractérisée en ce que le magasin d'outils est formé selon un unique circuit fermé constitué d'une chaîne de maillons, chaque maillon étant un support-mère.

Un avantage d'une machine-outil telle que définie ci-dessus est de fournir à la machine-outil une capacité de stockage élevée (typiquement 6000 outils), et une grande autonomie (typiquement 333 h pour une machine-outil munie de cinq stations d'usinage).

Selon une autre caractéristique avantageuse de la présente invention, la machine-outil telle que définie ci-dessus comprend en outre une interface d'opérateur située à une extrémité du bâti, et comporte des moyens de décharge/charge situés au voisinage d'une partie du magasin d'outils.

Un avantage d'une telle machine est de décharger et charger de façon automatique ou manuelle au moins un support-fille, de sorte que la machine-outil continue à réaliser des opérations d'usinage lors d'opérations de décharge/charge des supports-filles dans le magasin d'outils.

Selon une autre caractéristique avantageuse de la présente invention, la machine-outil telle que définie ci-dessus comprend en outre un capot mobile par rapport au bâti entre deux positions respectives, fermée et ouverte, le magasin d'outils étant mobile en translation le long des colonnes entre deux positions respectives, une première position dans laquelle le magasin d'outils est disposé au voisinage de la zone de travail et une seconde position dans laquelle le magasin d'outils est dégagé du voisinage de la zone de travail, et le capot étant solidaire du magasin d'outils.

Un avantage d'une telle machine-outil réside dans le fait que le capot passant de sa position fermée à sa position ouverte entraîne dans sa course le magasin d'outils de sa première position à sa seconde position, et libère l'accès de la zone de travail pour un utilisateur.

Selon d'autres caractéristiques avantageuses de la présente invention, la machine-outil telle que définie ci-dessus comprend en outre des moyens d'immobilisation; les moyens d'immobilisation étant constitués par au moins une pince comprenant deux branches et des éléments d'immobilisation.

Un avantage d'une telle machine-outil est de déterminer avec précision la position spatiale d'un support-fille, en supprimant tous les degrés de liberté de ledit support-fille, pour permettre un transfert d'outil entre le dispositif de transfert et ledit support-fille.

Un autre objet de la présente invention est de prévoir un magasin d'outils destiné à équiper une machine-outil, qui pallie les inconvénients de l'art antérieur.

Cet objet, ainsi que d'autres, est atteint par un magasin d'outils constitué d'une pluralité de supports-mères connectés les uns aux autres pour stocker une pluralité d'outils, chaque support-mère étant susceptible de recevoir et de maintenir une pluralité de supports-filles destinés à porter au moins deux outils, et destiné à équiper une machine-outil, caractérisé en ce qu'il est formé selon un unique circuit fermé constitué d'une chaîne de maillons, chaque maillon étant un support-mère.

Les objets, caractéristiques et avantages de la présente invention, ainsi que d'autres, apparaîtront plus clairement à la lecture de la description détaillée d'un mode de réalisation préféré de l'invention, donné à titre d'exemple uniquement, en relation avec les figures jointes, parmi lesquelles :
- la figure 1 représente une vue générale d'une machine-outil selon l'art antérieur;
- la figure 2 représente de façon plus détaillée un magasin d'outil de la figure 1;
- la figure 3 représente une vue générale d'un mode de réalisation préféré de machine-outil selon la présente invention;
- la figure 4 représente de façon détaillée une partie du magasin d'outils de la machine-outil de la figure 3;
- la figure 5 représente l'interface d'opérateur de la machine-outil de la figure 3;
- la figure 6 représente le magasin d'outils de la machine-outil de la figure 3;
- la figure 7 représente de façon plus détaillée un support-fille monté sur un support-mère du magasin d'outils de la figure 6;
- la figure 8 est une section partielle selon la ligne VIII-VIII du support-mère de la figure 7; et
- la figure 9 représente un mode de réalisation des moyens d'immobilisation des supports-filles.

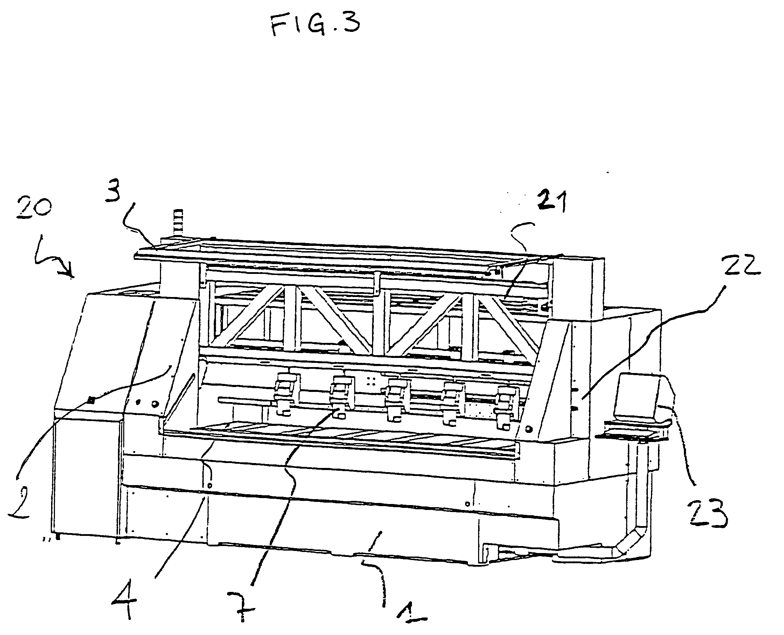

La figure 3 représente une vue générale d'un mode de réalisation préféré d'une machine-outil selon la présente invention.

On note que la structure de la machine-outil 20 représenté en figure 3 est proche de la structure de la machine-outil classique décrite ci-dessus. Par souci de simplicité, les composants représentés dans les figures 3 à 8, et désignés par les mêmes références que ceux représentés en figures 1 et 2 sont identiques à ceux désignés en figures 1 et 2.

Pour l'essentiel, la machine-outil 20 comprend en outre un magasin d'outils 21 unique et une interface d'opérateur 22. Des moyens de commande 23 sont prévus pour commander de façon automatique diverses opérations de la machine-outil 20, notamment la gestion du magasin d'outils 21.

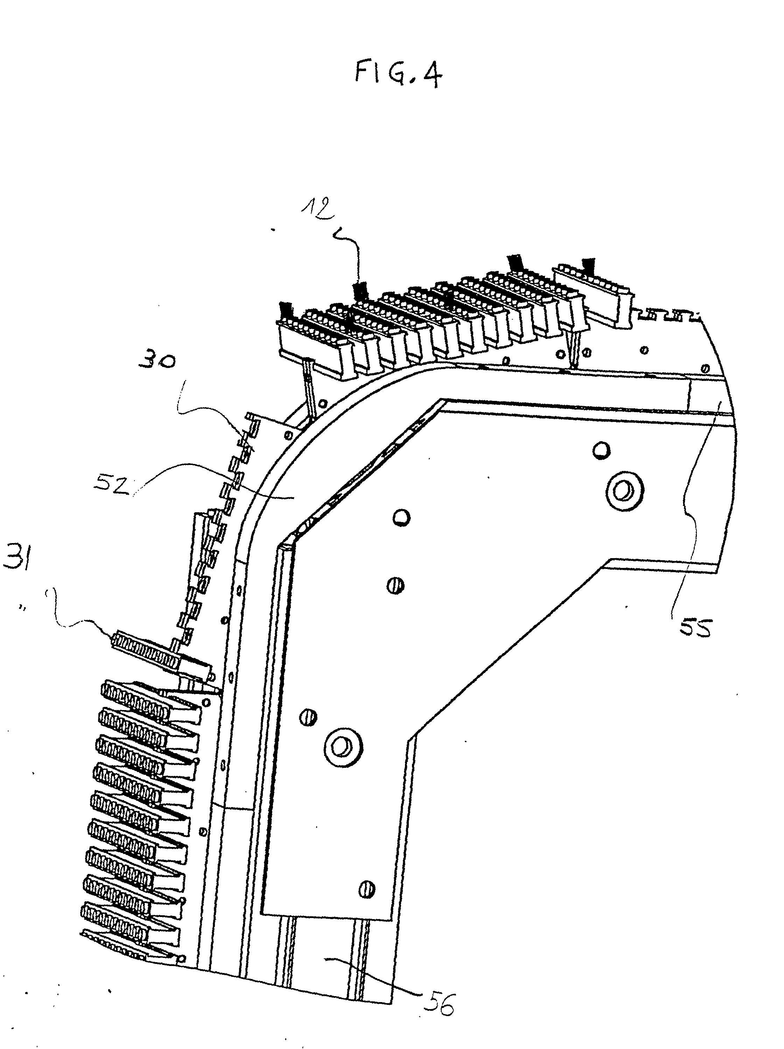

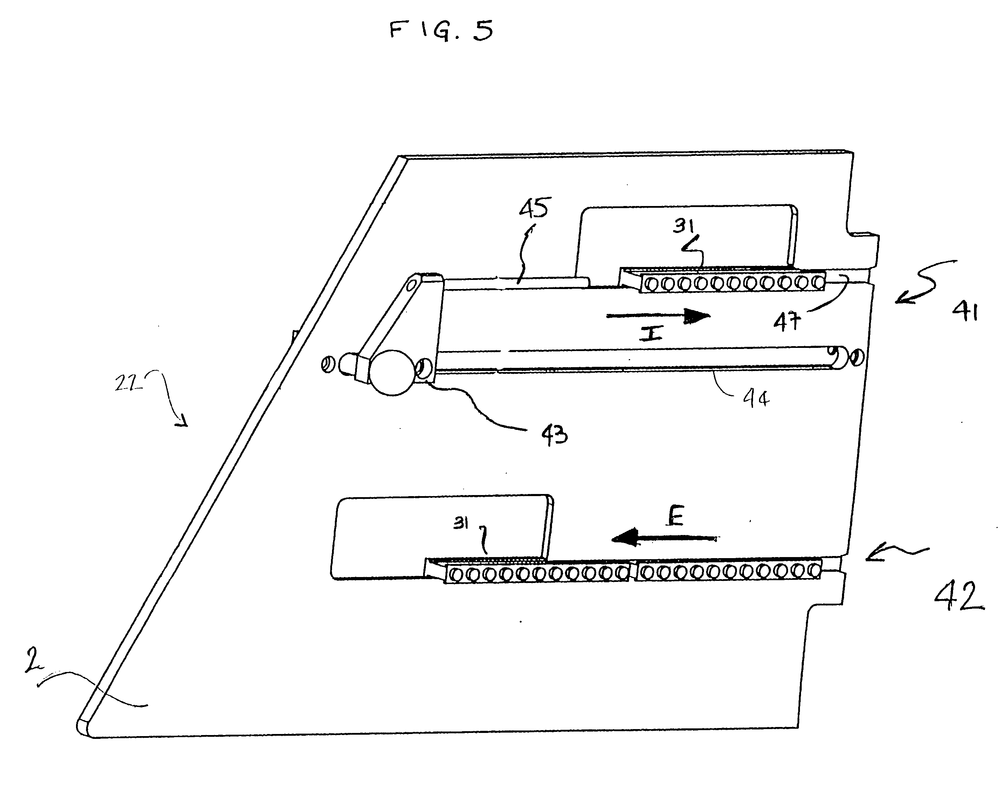

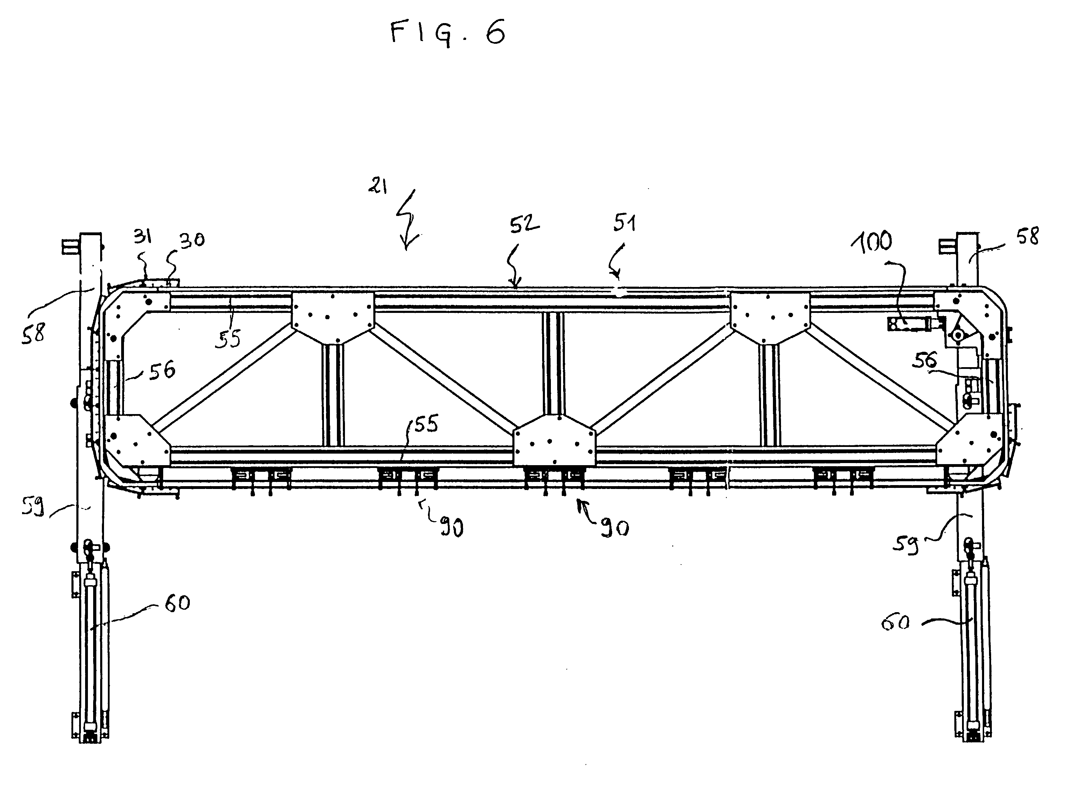

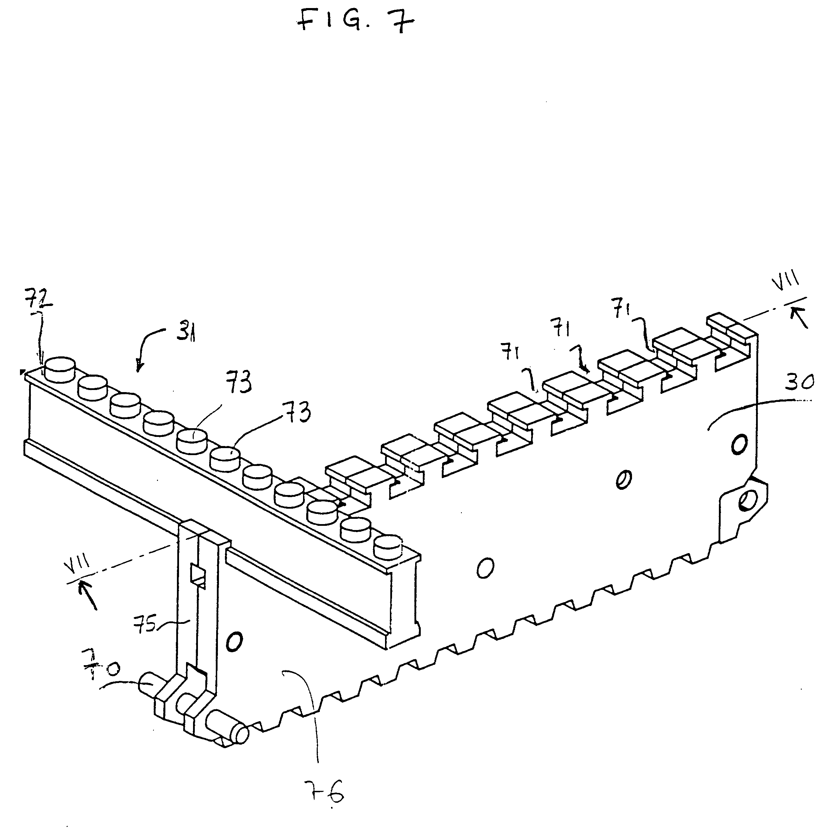

Le magasin d'outils 21 est formé selon un circuit fermé constitué d'une pluralité de supports-mères connectés les uns aux autres. La figure 4 représente à une échelle agrandie une partie d'un tel circuit. Chaque support-mère 30 est susceptible de recevoir et de maintenir une pluralité de supports-filles 31, et chaque support-fille 31 est destiné à porter au moins deux outils 12. Par souci de clarté, la figure 4 représente de façon détaillée une partie du magasin d'outils de la machine-outil de la figure 3. On notera que, dans le mode de réalisation préféré décrit ultérieurement de façon plus détaillée, le support-mère correspond au maillon 30 d'une chaîne de maillons (partiellement représentée en figure 4), et le support-fille correspond à une barrette 31 portant des outils 12.

La référence 22 désigne l'interface d'opérateur de décharge/charge destinée à décharger et charger de façon automatique ou manuelle des supports-filles 31, que l'on appelle ci-après "interface d'opérateur". Comme cela est représenté en figure 3, l'interface d'opérateur 22 est située à une extrémité du carter 2 de la machine-outil 20, et comprend essentiellement des moyens de décharge/charge situés au voisinage immédiat d'une partie du magasin d'outils 21. Plus précisément, ces moyens de décharge/charge comprennent des moyens d'introduction 41 pour introduire un support-fille 31 dans un support-mère 30 depuis l'extérieur de la machine-outil 20, et des moyens d'éjection 42 vers l'extérieur de la machine-outil pour extraire un support-fille 31 d'un support-mère 30.

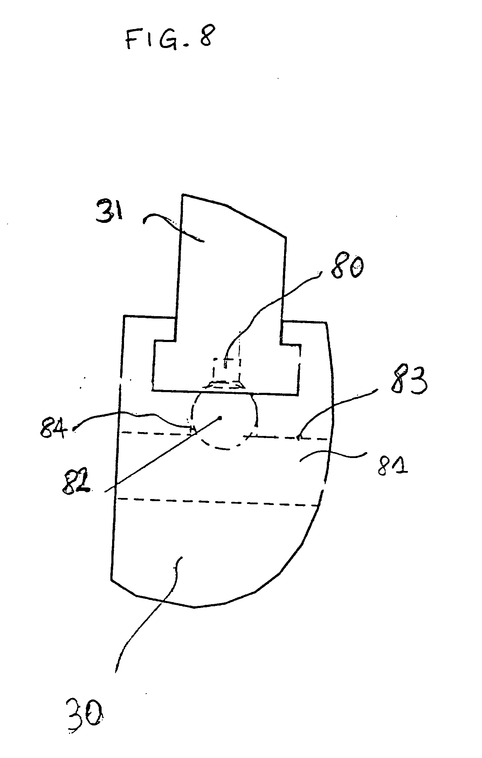

Selon le mode de réalisation préféré représenté en figure 5, les moyens d'introduction 41 comprennent au moins une culasse 43 qui coulisse dans une rainure oblongue 44 ménagée dans une paroi du carter 2 et susceptible d'être actionnée manuellement, la culasse 43 étant munie d'une tige d'actionnement 45 pour réaliser l'introduction d'un support-fille 31. Les moyens d'introduction 41 comprennent en outre des moyens de guidage de support-fille formés par une rainure 47 ayant une section profilée et s'étendant parallèlement à la rainure oblongue 44. Les moyens d'éjection 42 comprennent au moins un dispositif de type vérin (non représenté).

L'homme de l'art note que ces moyens de décharge/charge peuvent être commandés de façon automatique par les moyens de commande 23.

La figure 6 représente le magasin d'outils 21 de la machine-outil 20, selon le mode de réalisation préféré de la présente invention.

Le magasin d'outils 21 est constitué d'un châssis de base 51 pour supporter les supports-mères 30, le châssis de base 51 étant muni de moyens de guidage de support-mère 52 destinés à guider les supports-mères 30 tout le long du châssis de base 51. Le châssis de base 51 est formé par un cadre rigide de quatre poutres 55, 56, respectivement deux traverses 55 parallèles et deux montants 56 parallèles. Les moyens de guidage de support-mère 52 sont formés par une rainure à section profilée ménagée tout le long des poutres 55, 56, comme cela est mieux représenté en figure 4.

En outre, deux colonnes 58 solidaires du bâti 1 (non représenté en figure 6) sont reliées aux deux montants 56. Comme cela est représenté en figure 4, l'ensemble constitué du châssis de base 51 et des colonnes 58 est contenu dans un plan. Ce plan est situé en regard de la (ou des) station(s) d'usinage et, de préférence, dans un plan légèrement en avant des stations d'usinage, comme cela est représenté en figure 3.

Le châssis de base 51 est mobile en translation le long des colonnes entre deux positions respectives, une première position dans laquelle le magasin d'outils est disposé au voisinage de la zone de travail et une seconde position dans laquelle le magasin d'outils est dégagé du voisinage de la zone de travail, la figure 6 représentant le châssis de base 51maintenu dans la première position et la figure 3 représentant le châssis de base 51 maintenu dans la seconde positon. Ainsi, l'homme de l'art note que ladite seconde position correspond à une position de maintenance pour la machine-outil 20, et que la figure 3 ne représente donc pas la position la plus courante de la machine-outil 20, en état de fonctionnement.

Par ailleurs, la machine-outil 20 comprend en outre un capot 3. Le capot 3 est mobile par rapport au bâti 1 entre deux positions respectives, fermée et ouverte, la figure 3 représentant le capot 3 en position ouverte.

Le capot 3 est solidaire du châssis de base 51 de sorte que, lorsque le capot 3 passe de sa position fermée à sa position ouverte, le capot 3 entraîne dans sa course le châssis de base 51 de sa première position à sa seconde position. Ceci a pour effet de libérer l'accès de la zone de travail pour un utilisateur.

A cet effet, le châssis de base 51 comprend en outre deux éléments de liaison constitués chacun d'un manchon 59, comme cela est représenté en figure 6. Chaque manchon 59 est solidaire d'un montant 56, et peut coulisser sur la colonne correspondante 58. Chaque manchon 59 est également relié à un vérin de levage 60, dont le corps et la tige sont fixées respectivement à la colonne correspondante 58 et au manchon correspondant 59. Ceci a pour effet de faciliter le passage du châssis de base de la première position à la seconde position.

Comme le représente également la figure 6, le circuit fermé du magasin d'outils 21 est formé par une chaîne de maillons (représentée partiellement), qui peut être entraînée par des moyens moteurs 100, typiquement un moto-réducteur en réponse à des signaux de commande provenant des moyens de commande 23. Dans cette chaîne de maillons, chaque maillon constitue un support-mère 30.

La figure 7 représente de façon détaillée un maillon selon le mode de réalisation préféré.

Le maillon 30 est constitué de deux plaques 75, 76 identiques, fixées l'une à l'autre.

Le maillon 30 est articulé avec chacun de ses maillons voisins par une goupille 70 qui traverse l'épaisseur du maillon. La longueur de goupille 70 est supérieure à l'épaisseur du maillon 30, ce qui permet à la goupille 70 de coopérer avec la rainure des poutres 55, 56 du châssis de base 51, comme cela est représenté en figure 4.

Dans l'exemple représenté, le maillon 30 est également pourvu de dix glissières 71. Les glissières 71 sont identiques, et pourvues d'une direction de coulissement commune perpendiculaire au plan contenant le châssis de base 51, comme cela est représenté en figure 4. Il va de soi que le nombre de glissières de l'exemple représenté est purement indicatif, et peut varier selon des contraintes de conception.

On note en figure 7 qu'un support-fille 31 peut être engagé à coulissement dans chaque glissière 71. Selon le mode de réalisation préféré, le support-fille 31 est formé par une barrette dont la section transversale présente un profil déterminé. Une première face 72 de la barrette est pourvue de onze conduits cylindriques 73 indépendants ayant des axes parallèles entre eux. Ainsi, chaque conduit 73 peut recevoir un outil 12, comme cela est représenté en figure 4.

La figure 8 représente une section partielle d'une barrette 31 engagée dans une glissière 71 d'un maillon 30.

La face opposée à la première face 72 de la barrette 31 comprend des évidements de positionnement 80. Selon le mode de réalisation préféré, les conduits 73 sont traversants, et forment par leurs extrémités débouchant sur la face opposée de la première face 72 de la barrette 31 les évidements de positionnement 80.

Le maillon 30 comprend en outre des moyens de positionnement 81, 82 des barrettes 31 engagées dans les glissières 71. De préférence, les moyens de positionnement 81, 82 comprennent une bande en matière élastique 81 s'étendant dans un premier conduit 83 formé dans le maillon 30, et une pluralité de billes 82 disposées chacune dans des seconds conduits 84 débouchant, d'une part, dans le fond de la glissière 71 et, d'autre part, dans le premier conduit 83. La bande 81 exerce une force élastique de rappel sur la bille 82, de sorte que la bille 82 fait ainsi saillie dans le fond de la glissière 71 correspondante. La bille 82 est destinée à coopérer avec un des évidements 80 de la barrette 31 engagée dans la glissière 71 correspondante, comme cela est représenté en figure 8. Ceci a pour effet de maintenir la barrette 31 dans une position déterminée.

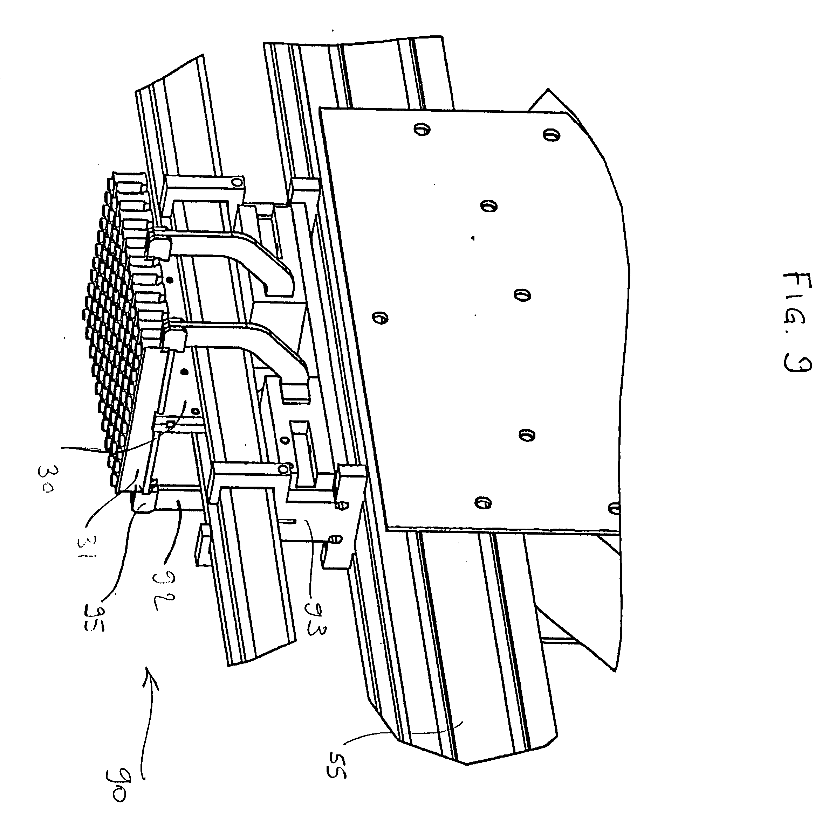

En relation avec les figures 6, et 9, le magasin d'outils 21 comprend aussi des moyens d'immobilisation 90. Les moyens d'immobilisation 90 sont essentiellement constitués d'une pince 92 fixée à une poutre du châssis de base 51, typiquement la traverse 55 inférieure dans le mode de réalisation préféré, par des éléments d'immobilisation 93. La pince 92 est formée par deux branches dont les extrémités sont pourvues d'éléments de préhension 95, et entre lesquelles passe la chaîne des maillons 30. Ainsi, à l'instar d'une mâchoire, la pince 92 peut pincer les extrémités d'une barrette 31, les éléments de préhension 95 étant appropriés à la géométrie desdites extrémités. Ceci a pour effet de supprimer tous les degrés de liberté de ladite barrette 31, comme cela est représenté en figure 9. Le mode de réalisation préféré représenté prévoit deux pinces 92 du type susmentionné, toutefois une seule pince suffit pour que l'ensemble fonctionne correctement.

Le fonctionnement d'une machine-outil du type représenté en figure 3 est le suivant.

Comme la structure de la machine-outil 20 est proche d'une structure classique, il va de soi que son fonctionnement est relativement proche du fonctionnement d'une machine-outil classique. ce fonctionnement étant supposé connu de l'homme de l'art.

Ainsi, les différents transferts d'outil sont classiquement réalisés, en particulier lors de la charge d'un outil 12 provenant d'une barrette 31 de la chaîne ou d'une station d'usinage 7 dans laquelle l'outil doit être remplacé.

Toutefois, le fonctionnement de la machine-outil du type représenté en figure 3 comprend des séquences de changement d'outil et de renouvellement de barrette différentes des séquences classiques.

Les moyens de programmation 23 divisent virtuellement la chaîne de maillons en plusieurs sous-ensembles ordonnés, chaque sous-ensemble comprenant autant de barrettes 31 que la machine-outil comprend de stations d'usinage 7. Ainsi, chacune des barrettes 31 de chaque sous-ensemble ordonné est attribuée à une seule station d'usinage 7. A titre d'exemple, les barrettes juxtaposées dans la chaîne étant numérotées de manière consécutive, pour une machine-outil à six stations d'usinage, l'ordre d'attribution des stations d'usinage est : 1 6 5 4 3 2; pour une machine-outil à quatre stations d'usinage comprenant chacune deux broches, l'ordre d'attribution des stations d'usinage est : 1 5 8 4 7 3 6 2. Les moyens de programmation 23 commandent le déplacement de la chaîne de maillons, et identifient la barrette 31 d'un sous-ensemble ordonné, de telle sorte que ladite barrette 31 est virtuellement associée à la station d'usinage 7 nécessitant un changement d'outil. La chaîne de maillons est ensuite entraînée, de façon à amener ladite barrette 31 au-dessous de la pince d'immobilisation. Les deux branches 92 de ladite pince d'immobilisation immobilisent alors ladite barrette.

Dans le mode de réalisation décrit, l'occupation de la barrette 31 par les outils 12 est telle qu'un emplacement vide est prévu pour recevoir un outil usagé. Sinon, la chaîne est à nouveau entraînée, de façon à fournir une nouvelle barrette affiliée à la même station d'usinage et contenant au moins un outil neuf.

Le changement des barrettes 31 a lieu par l'interface d'opérateur 22, de telle sorte que la machine-outil 20 continue à réaliser des opérations d'usinage lors d'opérations de décharge/charge des supports-filles 31 dans le magasin d'outils 21, et que l'opérateur n'intervient pas directement à l'intérieur de la machine-outil.

En effet, un vérin (non représenté) permet d'éjecter la barrette 31 concernée (typiquement une barrette pourvue uniquement d'outils usagés) à l'extérieur de la machine-outil, comme cela est représenté par la flèche désignée E en figure 5. Par ailleurs, l'opérateur peut introduire une barrette 31 à un emplacement vide sur un maillon de la chaîne de maillons, comme cela est représenté par la flèche désignée I en figure 5. Cette barrette 31 reçue par ledit maillon 30 est maintenue en contact intime avec le maillon 30 par les moyens de positionnement 81, 82 du maillon 30, comme cela est représenté en figure 8.

Des perfectionnements peuvent être apportés à un tel fonctionnement, par des modifications de la structure de machine-outil du type représenté en figure 2.

Un premier perfectionnement de la machine-outil selon la présente invention consiste à réaliser de façon automatique le remplacement des supports-filles (typiquement l'introduction de supports-filles comprenant des outils neufs et l'éjection de supports-filles comprenant des outils usagés), par exemple en reliant les moyens de remplacement à une unité de commande programmable reliée aux moyens de décharge/charge et des moyens moteurs.

Un second perfectionnement de la machine-outil selon la présente invention consiste à utiliser simultanément plusieurs pinces d'immobilisation en combinaison avec autant de changeurs, ces changeurs constituant un des dispositifs de transfert d'outil, ce qui a pour effet de diminuer le temps de cycle de remplacement d'un outil usagé, en effectuant le remplacement de l'outil en un temps minimal et un minimum de déplacements.

Il va de soi pour l'homme de l'art que la description détaillée ci-dessus peut subir diverses modifications sans sortir du cadre de la présente invention. Par exemple, comme variante, on peut modifier l'emplacement et la forme de la chaîne à l'intérieur du bâti de la machine-outil. On peut aussi modifier la forme et la contenance des maillons et des barrettes.

## Revendications

1. Machine-outil (20) destinée à réaliser des opérations d'usinage, notamment sur des plaques de circuits imprimés, comprenant :
- un bâti (1) ayant au moins une extrémité;
- un porte-pièces (4) solidaire du bâti (1);
- au moins une station d'usinage (7) propre à recevoir sélectivement un outil (12) pour exécuter les opérations d'usinage dans une zone de travail;
- des moyens de guidage pour assurer un mouvement relatif entre la (ou les) station(s) d'usinage et le porte-pièces;
- au moins un magasin d'outils (21) constitué d'une pluralité de supports-mères (30) connectés les uns aux autres pour stocker une pluralité d'outils (12), chaque support-mère étant susceptible de recevoir et de maintenir une pluralité de supports-filles (31) destinés à porter au moins deux outils (12).
- un dispositif de transfert d'outil (18) pour recevoir un outil (12); et
- des moyens de commande (23) sous l'action desquels est entraîné le magasin d'outils (21);
**caractérisée en ce que** le magasin d'outils (21) est formé selon un unique circuit fermé constitué d'une chaîne de maillons, chaque maillon étant un support-mère (30).

2. Machine-outil (20) selon la revendication 1, comprenant en outre une interface d'opérateur (22) située à une extrémité du bâti (1), et comportant des moyens de décharge/charge (41, 42) situés au voisinage d'une partie du magasin d'outils (21), pour décharger et charger de façon automatique ou manuelle au moins un support-fille (31), de sorte que la machine-outil (20) continue à réaliser des opérations d'usinage lors d'opérations de décharge/charge des supports-filles (31) dans le magasin d'outils (21).

3. Machine-outil (20) selon la revendication 2, **caractérisée en ce que** les moyens de décharge/charge (42, 41) comprennent des moyens d'éjection (42) vers l'extérieur de la machine-outil (20) pour extraire un support-fille (31) d'un support-mère (30), et des moyens d'introduction (41) pour introduire un support-fille (31) dans un support-mère (30) depuis l'extérieur de la machine-outil (20).

4. Machine-outil (20) selon la revendication 3, **caractérisée en ce que** les moyens d'introduction (41) comprennent au moins une culasse (43) qui coulisse dans une rainure oblongue (44) ménagée dans une paroi du bâti (1) et susceptible d'être actionnée manuellement, la culasse (43) étant munie d'une tige d'actionnement (45) pour réaliser l'introduction d'un support-fille (31), et **en ce que** les moyens d'éjection (42) comprennent au moins un dispositif de type vérin.

5. Machine-outil (20) selon la revendication 4, **caractérisée en ce que** les moyens d'introduction (41) comprennent en outre des moyens de guidage de support-fille formés par une rainure (47) ayant une section profilée et s'étendant parallèlement à la rainure oblongue (44).

6. Machine-outil (20) selon l'une quelconque des revendications précédentes, **caractérisée en ce que** le circuit fermé du magasin d'outils (21) est constitué d'un châssis de base (51) pour supporter les supports-mères (30), le châssis de base (51) étant muni de moyens de guidage de support-mère (52) destinés à guider les supports-mères (30) tout le long du châssis de base (51).

7. Machine-outil (20) selon la revendication 6, **caractérisée en ce que** le châssis de base (51) est formé par un cadre rigide de quatre poutres (55, 56) constituées de deux traverses parallèles (55) et de deux montants parallèles (56).

8. Machine-outil (20) selon la revendication 7, **caractérisée en ce que** les moyens de guidage de support-mère (52) sont formés par une rainure à section profilée ménagée tout le long des poutres (55, 56) du cadre.

9. Machine-outil (20) selon la revendication 8, **caractérisée en ce qu'**elle comprend en outre deux colonnes (58) solidaires du bâti (1) et reliées aux deux montants du cadre (56), de sorte que le châssis de base (51) et les colonnes (58) sont contenus dans un plan situé en regard de la (ou les) station(s) d'usinage (7).

10. Machine-outil (20) selon la revendication 9, **caractérisée en ce qu'**elle comprend en outre un capot (3) mobile par rapport au bâti (1) entre deux positions respectives, fermée et ouverte, **en ce que** le magasin d'outils (21) est mobile en translation le long des colonnes (58) entre deux positions respectives, une première position dans laquelle le magasin d'outils (21) est disposé au voisinage de la zone de travail et une seconde position dans laquelle le magasin d'outils (21) est dégagé du voisinage de la zone de travail, et **en ce que** le capot (3) est solidaire du magasin d'outils (21), de sorte que le capot (3) passant de sa position fermée à sa position ouverte entraîne dans sa course le magasin d'outils (21) de sa première position à sa seconde position, et libère l'accès de la zone de travail pour un opérateur.

11. Machine-outil (20) selon la revendication 10, **caractérisée en ce qu'**elle comprend en outre deux éléments de liaison et deux vérins de levage (60), **en ce que** chaque élément de liaison est constitué d'un manchon (59) qui vient coulisser sur une colonne (58), et est solidaire du montant (56) correspondant à ladite colonne (58), et **en ce que** chaque vérin (60) relie un manchon (59) à ladite colonne (58), de sorte que les vérins (60) de levage combinés aux manchons (59) facilitent le passage du châssis de base (51) de la première position à la seconde position.

12. Machine-outil (20) selon la revendication 11, **caractérisée en ce que** les première et seconde extrémités de chaque vérin (60) sont fixées respectivement à la colonne (58) correspondante et au manchon correspondant (59).

13. Machine-outil (20) selon l'une quelconque des revendications précédentes, **caractérisée en ce que** la chaîne de supports-mères (30) est entraînée par des moyens moteurs (100) en réponse aux moyens de commande (23).

14. Machine-outil (20) selon les revendications 8 et 13, **caractérisée en ce que** chaque maillon (30) est formé par deux plaques identiques (75, 76), et est articulé avec chacun de ses maillons voisins par une goupille (70) qui traverse l'épaisseur du maillon, **en ce que** la longueur de goupille est supérieure à l'épaisseur de maillon, et **en ce que** la goupille (70) coopère avec la rainure des poutres (55, 56) du châssis de base (51) pour guider le maillon (30).

15. Machine-outil (20) selon la revendication 14, **caractérisée en ce que** chaque maillon (30) est pourvu de glissières (71) dans lesquelles les supports-filles (31) peuvent être engagés à coulissement.

16. Machine-outil (20) selon la revendication 15, **caractérisée en ce que** les glissières (71) sont identiques, et pourvues d'une direction de coulissement commune perpendiculaire au plan contenant le châssis de base (51).

17. Machine-outil (20) selon la revendication 16, **caractérisée en ce que** le support-fille (31) est formé par une barrette ayant un profil déterminé, **en ce qu'**une première face (72) de la barrette est pourvue d'au moins deux conduits (73) cylindriques et **en ce que** chaque conduit (73) de la barrette peut recevoir un outil (12).

18. Machine-outil (20) selon la revendication 17, **caractérisée en ce que** la face opposée à la première face (72) de la barrette comprend des évidements de positionnement (80).

19. Machine-outil (20) selon la revendication 17, **caractérisée en ce que** les conduits (73) sont traversants, de façon à former des évidements de positionnement (80) quand lesdits conduits (73) débouchent sur la face opposée de la première face (72) de la barrette.

20. Machine-outil (20) selon la revendication 18, **caractérisée en ce que** le maillon (30) comprend des moyens de positionnement (81, 82) des barrettes engagées sur le maillon.

21. Machine-outil (20) selon la revendication 20, **caractérisée en ce que** les moyens de positionnement (81, 82) comprennent une bande en matière élastique (81) s'étendant dans un premier conduit (83) formé dans le maillon (30), et une pluralité de billes (82) disposées chacune dans des seconds conduits (84) débouchant, d'une part, dans le fond de chaque glissière (71) et, d'autre part, dans le premier conduit (83), la bande (81) exerçant une force élastique de rappel sur chaque bille (82), de sorte que chaque bille (82) fait ainsi saillie dans le fond de la glissière (71) correspondante, chaque bille (82) étant destinée à coopérer avec un des évidements de positionnement (80) d'une barrette engagée dans la glissière (71) correspondante pour maintenir ladite barrette dans une position déterminée.

22. Machine-outil (20) selon l'une quelconque des revendications précédentes, comprenant en outre des moyens d'immobilisation (90) destinés à immobiliser un support-fille (31) par rapport au dispositif de transfert (18).

23. Machine-outil (20) selon la revendication 22, **caractérisée en ce que** les moyens d'immobilisation (90) sont constitués par au moins une pince (92) fixée à une des poutres (55, 56) du châssis de base (51), par des éléments d'immobilisation (93), la pince (92) étant formée par deux branches dont les extrémités sont pourvues d'éléments de préhension (95) appropriés à la géométrie des extrémités d'une barrette, et entre lesquelles passe la chaîne des maillons (30) de sorte que, à l'instar d'une mâchoire, la pince (92) peut pincer les extrémités d'une barrette.

24. Magasin d'outils (21) constitué d'une pluralité de supports-mères (30) connectés les uns aux autres pour stocker une pluralité d'outils (12), chaque support-mère (30) étant susceptible de recevoir et de maintenir une pluralité de supports-filles (31) destinés à porter au moins deux outils (12), et destiné à équiper une machine-outil (20), **caractérisé en ce qu'**il est formé selon un unique circuit fermé constitué d'une chaîne de maillons, chaque maillon étant un support-mère (30).

## Patentansprüche

1. Werkzeugmaschine (20), die dazu vorgesehen ist, Bearbeitungsvorgänge insbesondere an Platten mit gedruckten Schaltungen vorzunehmen, und umfasst:
- einen Sockelrahmen (1), der wenigstens ein Ende besitzt;
- einen mit dem Sockelrahmen (1) fest verbundenen Werkstückträger (4);
- wenigstens eine Bearbeitungsstation (7), die wahlweise ein Werkzeug (12) aufnehmen kann, um die Bearbeitungsvorgänge in einer Arbeitszone auszuführen;
- Führungsmittel, die eine Relativbewegung zwischen der (oder den) Bearbeitungsstation(en) und dem Werkstückträger sicherstellen;
- wenigstens ein Werkzeugmagazin (21), das aus mehreren Mutterträgern (30) gebildet ist, die miteinander verbunden sind, um mehrere Werkzeuge (12) zu lagern, wobei jeder Mutterträger mehrere Tochterträger (31), die dazu bestimmt sind, wenigstens zwei Werkzeuge (12) zu tragen, aufnehmen und halten kann;
- eine Werkzeugübertragungsvorrichtung (18), die ein Werkzeug (12) aufnimmt;
- Steuermittel (23), unter deren Wirkung das Werkzeugmagazin (21) angetrieben wird;
**dadurch gekennzeichnet, dass** das Werkzeugmagazin (21) als einziger geschlossener Kreis ausgebildet ist, der aus einer Gliederkette gebildet ist, wobei jedes Glied ein Mutterträger (30) ist.

2. Werkzeugmaschine (20) nach Anspruch 1, die außerdem eine Mensch/Maschine-Schnittstelle (22) umfasst, die sich an einem Ende des Sockelrahmens (1) befindet und Entladungs-/Lademittel (41, 42) aufweist, die sich in der Nähe eines Teils des Werkzeugmagazins (21) befinden, um in automatischer oder manueller Weise wenigstens einen Tochterträger (31) zu entladen oder zu laden, derart, dass die Werkzeugmaschine (20) während des Entiade-/Ladebetriebs der Tochterträger (31) in das Werkzeugmagazin (21) fortgesetzt Bearbeitungsvorgänge ausführt.

3. Werkzeugmaschine (20) nach Anspruch 2, **dadurch gekennzeichnet, dass** die Entlade-/Lademittel (42, 41) Mittel (42) zum Auswerfen in die äußere Umgebung der Werkzeugmaschine (20), um einen Tochterträger (31) aus einem Mutterträger (30) zu entnehmen, und Einführmittel (41), um einen Tochterträger (31) von der äußeren Umgebung der Werkzeugmaschine (30) in einen Mutterträger (30) einzuführen, umfassen.

4. Werkzeugmaschine (20) nach Anspruch 3, **dadurch gekennzeichnet, dass** die Einführmittel (41) wenigstens einen Kopf (43) aufweisen, der in einer in einer Wand des Sockelrahmens (1) ausgesparten länglichen Nut (44) gleitet und manuell betätigt werden kann, wobei der Kopf (43) mit einem Betätigungsstift (45) versehen ist, um das Einführen eines Tochterträgers (31) auszuführen, und dass die Auswurfmittel (42) wenigstens eine Vorrichtung des Zylindertyps umfassen.

5. Werkzeugmaschine (20) nach Anspruch 4, **dadurch gekennzeichnet, dass** die Einführmittel (41) außerdem Tochterträger-Führungsmittel umfassen, die durch eine Nut (47) gebildet sind, die einen profilierten Querschnitt besitzt und sich parallel zu der länglichen Nut (44) erstreckt.

6. Werkzeugmaschine (20) nach einem der vorhergehenden Ansprüche, **dadurch gekennzeichnet, dass** der geschlossene Kreis des Werkzeugmagazins (21) aus einem Grundchassis (51) gebildet ist, das die Mutterträger (30) trägt, wobei das Grundchassis (51) mit Mutterträger-Führungsmitteln (52) versehen ist, die dazu bestimmt sind, die Mutterträger (30) auf der gesamten Länge des Grundchassis (51) zu führen.

7. Werkzeugmaschine (20) nach Anspruch 6, **dadurch gekennzeichnet, dass** das Grundchassis (51) durch einen starren Rahmen aus vier Trägem (55, 56) gebildet ist, die aus zwei parallelen Querträgern (55) und zwei parallelen Pfosten (56) gebildet sind.

8. Werkzeugmaschine (20) nach Anspruch 7, **dadurch gekennzeichnet, dass** die Mutterträger-Führungsmittel (52) aus einer Nut mit profiliertem Querschnitt gebildet sind, die auf der gesamten Länge der Träger (55, 56) des Rahmens ausgespart ist.

9. Werkzeugmaschine (20) nach Anspruch 8, **dadurch gekennzeichnet, dass** sie außerdem zwei mit dem Sockelrahmen (1) fest verbundene Säulen (58) umfasst, die mit den zwei Pfosten des Rahmens (56) verbunden sind, derart, dass das Grundchassis (51) und die Säulen (58) in einer Ebene liegen, die sich gegenüber der (oder den) Bearbeitungsstation(en) (7) befindet.

10. Werkzeugmaschine (20) nach Anspruch 9, **dadurch gekennzeichnet, dass** sie außerdem eine Abdeckklappe (3) umfasst, die in Bezug auf den Sockelrahmen (1) zwischen zwei Positionen, nämlich einer geschlossenen Position und einer geöffneten Position, beweglich ist, dass das Werkzeugmagazin (21) längs der Säulen (58) zwischen zwei Positionen, nämlich einer ersten Position, in der sich das Werkzeugmagazin (21) in der Nähe der Arbeitszone befindet, und einer zweiten Position, in der das Werkzeugmagazin (21) aus der Umgebung der Arbeitszone freigegeben ist, translatorisch beweglich ist, und dass die Abdeckklappe (3) mit dem Werkzeugmagazin (21) fest verbunden ist, derart, dass die Abdeckklappe (3) dann, wenn sie sich aus ihrer geschlossenen Position in ihre geöffnete Position bewegt, auf ihrer Bahn das Werkzeugmagazin (21) aus seiner ersten Position in seine zweite Position mitnimmt und den Zugang in die Arbeitszone für eine Bedienungsperson freigibt.

11. Werkzeugmaschine (20) nach Anspruch 10, **dadurch gekennzeichnet, dass** sie außerdem zwei Verbindungselemente und zwei Hubzylinder (60) umfasst, dass jedes Verbindungselement aus einer Hülse (59), die auf einer Säule (58) gleitet, gebildet ist und mit dem der Säule (58) entsprechenden Pfosten (56) fest verbunden ist, und dass jeder Zylinder (60) eine Hülse (59) mit der Säule (58) verbindet, derart, dass die mit den Hülsen (59) kombinierten Hubzylinder (60) den Übergang des Grundchassis (51) von der ersten Position in die zweite Position erleichtern.

12. Werkzeugmaschine (20) nach Anspruch 11, **dadurch gekennzeichnet, dass** das erste und das zweite Ende jedes Zylinders (60) an der entsprechenden Säule (58) bzw. an der entsprechenden Hülse (59) befestigt sind.

13. Werkzeugmaschine (20) nach einem der vorhergehenden Ansprüche, **dadurch gekennzeichnet, dass** die Kette von Mutterträgem (30) durch Motormittel (100) in Reaktion auf Steuermittel (23) angetrieben wird.

14. Werkzeugmaschine (20) nach den Ansprüchen 8 und 13, **dadurch gekennzeichnet, dass** jedes Glied (30) aus zwei gleichen Platten (75, 76) gebildet ist und an jedem seiner benachbarten Glieder durch einen Zapfen (70) angelenkt ist, der in Dickenrichtung des Gliedes verläuft, dass die Länge des Zapfens größer als die Dicke des Gliedes ist und dass der Zapfen (70) mit der Nut der Träger (55, 56) des Grundchassis (51) zusammenwirkt, um das Glied (30) zu führen.

15. Werkzeugmaschine (20) nach Anspruch 14, **dadurch gekennzeichnet, dass** jedes Glied (30) mit Gleitschlenen (71) versehen ist, in denen die Tochterträger (31) in einen Gleiteingriff gelangen können.

16. Werkzeugmaschine (20) nach Anspruch 15, **dadurch gekennzeichnet, dass** die Gleitschienen (71) gleich sind und eine gemeinsame Gleitrichtung besitzen, die zu der das Grundchassis (51) enthaltenden Ebene senkrecht ist.

17. Werkzeugmaschine (20) nach Anspruch 16, **dadurch gekennzeichnet, dass** der Tochterträger (31) durch einen Steg mit einem gegebenen Profil gebildet ist, dass eine erste Fläche (72) des Stegs mit wenigstens zwei zylindrischen Kanälen (73) versehen ist und dass jeder Kanal (73) des Stegs ein Werkzeug (12) aufnehmen kann.

18. Werkzeugmaschine (20) nach Anspruch 17, **dadurch gekennzeichnet, dass** die der ersten Fläche (72) gegenüberliegende Fläche des Stegs Positionierungsaussparungen (80) umfasst.

19. Werkzeugmaschine (20) nach Anspruch 17, **dadurch gekennzeichnet, dass** die Kanäle (73) durchbohrt sind, derart, dass die Positionlerungsaussparungen (80) gebildet werden, wo die Kanäle (73) in die der ersten Fläche (72) des Stegs gegenüberliegende Fläche münden.

20. Werkzeugmaschine (20) nach Anspruch 18, **dadurch gekennzeichnet, dass** das Glied (30) Mittel (81, 82) für die Positionierung der an dem Glied in Eingriff befindlichen Stege umfasst.

21. Werkzeugmaschine (20) nach Anspruch 20, **dadurch gekennzeichnet, dass** die Positionierungsmittel (81, 82) ein Band (81) aus elastischem Material, das sich in einem ersten Kanal (83) erstreckt, der in dem Glied (30) gebildet ist, und mehrere Kugeln (82), die jeweils In den zweiten Kanälen (84) angeordnet sind, die einerseits in den Boden jeder Gleitschiene (71) und andererseits in den ersten Kanal (83) münden, umfassen, wobei das Band (81) auf jede Kugel (82) eine elastische Rückstellkraft ausübt, derart, dass jede Kugel (82) somit in den Boden der entsprechenden Gleitschiene (71) vorsteht, wobei jede Kugel (82) dazu bestimmt ist, mit einer der Positionierungsaussparungen (80) eines in der entsprechenden Gleitschiene (71) in Eingriff befindlichen Stegs zusammenzuwirken, um den Steg in einer bestimmten Position zu halten.

22. Werkzeugmaschine (20) nach einem der vorhergehenden Ansprüche, die außerdem Unbeweglichmachungsmittel (90) aufweist, die dazu bestimmt sind, einen Tochterträger (39) in Bezug auf die Übertragungsvorrichtung (18) unbeweglich zu machen.

23. Werkzeugmaschine (20) nach Anspruch 22, **dadurch gekennzeichnet, dass** die Unbeweglichmachungsmittel (90) durch wenigstens eine Klaue (72) gebildet sind, die an einem der Träger (55, 56) des Grundchassis (51) durch Unbeweglichmachungselemente (93) befestigt ist, wobei die Klaue (92) durch zwei Schenkel gebildet ist, deren Enden mit Vorbelastungselementen (95) versehen sind, die für die Geometrie der Enden eines Stegs geeignet sind und zwischen denen die Kette aus Gliedern (30) verläuft, derart, dass die Klaue (92) wie eine Klemmbacke die Enden eines Stegs einklemmen kann.

24. Werkzeugmagazin (21), das aus mehreren Mutterträgern (30) gebildet ist, die miteinander verbunden sind, um mehrere Werkzeuge (12) zu lagern, wobei jeder Mutterträger (30) mehrere Tochterträger (31), die dazu bestimmt sind, wenigstens zwei Werkzeuge (12) zu tragen, aufnehmen und halten kann und dazu bestimmt ist, eine Werkzeugmaschine (20) auszurüsten, **dadurch gekennzeichnet, dass** es als ein einziger geschlossener Kreis ausgebildet ist, der aus einer Gliederkette gebildet ist, wobei jedes Glied ein Mutterträger (30) ist.

## Claims

1. Machine-tool (20) intended to perform machining operations, in particular on printed circuit boards, including :
- a frame (1) having at least one end;
- a workpiece carrier (4) attached to said frame (1) ;
- at least one machining station (7) able to accommodate selectively a tool (12) for performing the machining operations in a working area;
- guiding means for assuring a relative moment between the machining station(s) and the workpiece carrier;
- at least one tool magazine (21) formed of a plurality of interconnected main supports (30) for storing a plurality of tools (12), each main support being arranged to accommodate and hold a plurality of subsidiary supports (31) arranged to carry at least two tools (12);
- a tool transfer device (18) for accommodating a tool (12); and
- control means (23) via whose action the tool magazine (21) is driven;
**characterised in that** the tool magazine (21) is formed according to a unique closed circuit made of a link chain, each link being a main support (30).

2. Machine-tool (20) according to claim 1, further including an operator interface (22) at one end of the frame (1), and including unloading/loading means (41, 42) situated in the vicinity of a part of the tool magazine (21), for automatically or manually unloading and loading at least one subsidiary support (31), so that the machine-tool (20) continues to perform machining operations during unloading/loading of the subsidiary supports (31) in the tool magazine (21).

3. Machine-tool (20) according to claim 2, **characterised in that** the unloading/loading means (41, 42) include means (42) for ejecting a subsidiary support (31) outside the machine-tool (20) for extracting a subsidiary support (31) from a main support (30), and means (41) for introducing a subsidiary support (31) onto a main support (30) from outside the machine-tool (20).

4. Machine-tool (20) according to claim 3, **characterised in that** the introducing means (41) include at least one slide block (43) which slides in an oblong groove (44) which is arranged in a wall of the frame (1) and is capable of being manually actuated, the slide block (43) being fitted with an actuating rod (45) for introducing a support (31), and **in that** the ejection means (42) include at least one jack type device.

5. Machine-tool (20) according to claim 4, **characterised in that** the introducing means (41) further include subsidiary support guiding means formed by a groove (47) having a profiled cross-section and extending parallel to the oblong groove (44).

6. Machine-tool (20) according to any one of the preceding claims, **characterised in that** the tool magazine (21) is formed of a base chassis (51) for supporting the interconnected main supports (30), the base chassis (51) being fitted with main support guiding means (52) for guiding the main supports (30) all the way along the base chassis (51).

7. Machine-tool (20) according to claim 6, **characterised in that** the base chassis (51) is formed by a rigid frame having four beams (55, 56) consisting of two parallel transverse beams (55) and two parallel vertical beams (56).

8. Machine-tool (20) according to claim 7, **characterised in that** the main support guiding means (52) are formed by a groove having a profiled cross-section arranged all the way along the beams (55, 56) forming the frame.

9. Machine-tool (20) according to claim 8, **characterised in that** it further includes two columns (58) attached to the frame (1) and connected to two vertical beams (56) of the base chassis, so that the base chassis (51) and the columns (58) extend in a plane situated in front of the machining station(s) (7).

10. Machine-tool (20) according to claim 9, **characterised in that** it further includes a hood (3) able to move with respect to the frame (1) between two respective closed and open positions, **in that** the tool magazine (21) is able to move in translation along the columns (58) between two respective positions, a first position in which the tool magazine (21) is disposed in the vicinity of the working area and a second position in which the tool magazine (21) is not in the vicinity of the working area, and **in that** the hood (3) is attached to the tool magazine (21), so that in passing from its closed position to its open position the hood (3) drives in its travel the tool magazine (21) from its first position to its second position, and allows access to the working area by an operator.

11. Machine-tool (20) according to claim 10, **characterised in that** it further includes two connecting elements and two jacks (60), **in that** each connecting element is formed of a sleeve (59) which slides on a column (58), and is attached to the vertical beam (56) corresponding to said column (58), and **in that** each jack (60) connects a sleeve (59) to said column (58), so that the jacks (60) combined with the sleeves (59) drive the base chassis (51) from the first position to the second position.

12. Machine-tool (20) according to claim 11, **characterised in that** the first and second ends of each jack (60) are fixed respectively to the corresponding column (58) and the corresponding sleeves (59).

13. Machine-tool (20) according to any one of the preceding claims, **characterised in that** the chain of main supports (30) is driven by motor means (100) in response to the control means (23).

14. Machine-tool (20) according to claims 8 and 13, **characterised in that** each link (30) is formed by two identical plates (75, 76), and is hinged to each of its neighbouring links by a pin (70) which passes through the thickness of the link, **in that** the pin length is greater than the link thickness, and **in that** the pin (70) co-operates with the groove of the beams (55, 56) of the base chassis (51) to guide the link (30).

15. Machine-tool (20) according to claim 14, **characterised in that** each link (30) is provided with slide ways (71) in each of which a subsidiary support (31) can be engaged by sliding.

16. Machine-tool (20) according to claim 15, **characterised in that** the slide ways (71) are identical, and have a common sliding direction which is perpendicular to the plane containing the base chassis (51).

17. Machine-tool (20) according to claim 16, **characterised in that** the subsidiary support (31) is formed by a bar having a determined profile, **in that** a first face (72) of the bar is provided with at least two independent cylindrical conduits (73) having parallel axes to each other and **in that** each conduit (73) of the bar can accommodate a tool (12).

18. Machine-tool (20) according to claim 17, **characterised in that** the face opposite the first face (72) of the bar includes positioning recesses (80).

19. Machine-tool (20) according to claim 17, **characterised in that** the conduits (73) are through conduits, so as to form the positioning recesses (80) when said conduits (73) open out onto the face opposite the first face (72) of the bar.

20. Machine-tool (20) according to claim 18, **characterised in that** the link (30) includes means (81, 82) for positioning the bars engaged on the link.

21. Machine-tool (20) according to claim 20, **characterised in that** the positioning means (81, 82) include a strip (82) made of a resilient material extending into a first conduit (83) formed in the link (30), and a plurality of balls (82) each disposed in second conduits (84) opening out, on the one hand, into the base of each slide way (71) and, on the other hand, into the first conduit (83), the strip (81) exerting a resilient return force onto each ball (82), so that each ball (82) thus projects into the base of the corresponding slide way (71), each ball (82) being intended to co-operate with one of the positioning recesses (80) of a bar engaged in the corresponding slide way (71) to hold said bar in a determined position.

22. Machine-tool (20) according to any one of the preceding claims, further including means (90) for immobilising a subsidiary support (31) with respect to the transfer device (18).

23. Machine-tool (20) according to claim 22, **characterised in that** the immobilising means (90) are formed by at least one clamp (92) fixed to one of the beams (55, 56) of the base chassis (51) by immobilising elements (93), the clamp (92) being formed by two branches whose ends are provided with gripping elements (95) suited to the shape of the ends of a bar, and between which the link chain (30) passes so that the clamp (92) can grip the ends of a bar in the manner of a jaw.

24. Tool magazine (21) formed of a plurality of interconnected main supports (30) for storing a plurality of tools (12), each main support (30) being arranged to accommodate and hold a plurality of subsidiary supports (31) intended to carry at least two tools (12), and arranged to be fitted to a machine-tool (20), **characterised in that** it is formed as a unique closed circuit formed of a link chain, each link being a main support (30).
